# EUROPÄISCHE PATENTANMELDUNG

(11) **EP 0 993 029 A2**
(43) Veröffentlichungstag der Anmeldung: **12.04.2000**
(21) Anmeldenummer: 99118102.5
(22) Anmeldetag: 10.09.1999
(51) Int. Cl.: H01L 21/306, H01L 21/324

(54) **Verfahren zur Herstellung kristalliner Halbleiterschichten**

(30) Priorität: 10.09.1998 DE 19841430
(71) Anmelder: Universität Stuttgart , Institut für Physikalische Elektronik, 70569 Stuttgart (DE)
(72) Erfinder: Bergmann, Ralf, 70565 Stuttgart (DE); Rinke, Titus, 89077 Ulm (DE); Werner, J.H., 70197 Stuttgart (DE)
(74) Vertreter: Graf Lambsdorff, Matthias, Dr.

(57) **Zusammenfassung**

Ein Verfahren zur Herstellung einer kristallinen Halbleiterschicht (26) besteht darin, daß an der Oberfläche eines Halbleitersubstrats (20; 30) mindestens eine poröse Schicht (21; 31) erzeugt wird, die poröse Schicht von dem Haibleitersubstrat abgelöst wird und entweder vor oder nach dem Ablösen durch thermisches Ausheilen mindestens teilweise rekristallisiert wird.

## Beschreibung

Die Erfindung betrifft ein Verfahren zur Herstellung kristalliner Halbleiterschichten gemäß Patentanspruch 1.

Für elektronische Bauelemente wie beispielsweise Dünnfilmtransistoren oder Dünnschichtsolarzellen werden dünne Halbleiterschichten mit geringer Defektdichte, hoher Diffusionslänge bzw. Ladungsträgerbeweglichkeit benötigt. Vor allem bei Solarzellen ist es jedoch für die Anwendung von erheblichem Vorteil, wenn die photeaktiven Halbleiterschichten auf Fremdsubstrate wie Glas oder Kunststoff aufgebracht werden können. Bei der Abscheidung von kristallinen Halbleiterschichten auf solchen Fremdsubstraten ist jedoch ein epitaktisches Wachstum im allgemeinen nicht möglich. Das Wachstum führt daher zur Bildung von polykristallinen Schichten, deren Eigenschaften durch die Anwesenheit von Korngrenzen beeinträchtigt werden. Für die Nutzung als elektronische oder optoelektronische Bauelemente ist dies zumeist von Nachteil.

Um dieses Problem zu lösen, sind gemäß dem Stand der Technik eine Reihe von unterschiedlichen Technologien vorgeschlagen und angewandt worden.

Der einfachste Ansatz besteht darin, kristalline Blöcke oder Stäbe von einkristallinem Halbleitermaterial mechanisch zu zersägen, wie beispielsweise beschrieben in der Publikation von J. Dietl et al. in 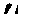 Crystals: Growth, Properties and Applications", S. 73, Bd. 8, Springer Verlag, 1982. Die mit diesem Verfahren erzielbaren minimalen Schichtdicken liegen allerdings in einem Bereich von derzeit etwa 130µm. Ein großes Problem ist im übrigen der sehr hohe Sägeschnittverlust.

Durch ein als Edge defined Film Fed Growth (EFG) bezeichnetes Verfahren, beschrieben in der Publikation von F.V.Wald in 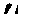 Crystals: Growth, Properties and Applications", S. 157, Bd. 5, Springer Verlag, 1981, kann eine sehr dünne Siliziumfolie hergestellt werden. Mit diesem Verfahren können zwar die Sägeschnittverluste vermieden werden, jedoch beträgt die Dicke der Folien derzeit typischerweise 300µm. Es ist bisher noch nicht möglich gewesen, die minimal erzielbare Schichtdicke auf etwa 100µm zu verringern. Die Herstellung von semi-transparenten Si-Schichten wie sie für Display-Anwendungen nötig sind, ist mit diesem Verfahren nicht möglich.

Die Rekristallisation von auf Fremdsubstraten abgeschiedenen amorphen oder polykristallinen Halbleiterschichten mittels Laserstrahl oder dergleichen hat sich einerseits als aufwendig und andererseits beim Durchsatz als nicht zufriedenstellend herausgestellt.

Bei dem sogenannten Smart-Cut-Prozeß, wie beispielsweise beschrieben in der US-PS-5,714,395, werden in einen Halbleiterwafer Ionen derart implantiert, daß sich in einer bestimmten, durch die Implantationsparameter vorgegebenen Tiefe des Halbleiterwafers Mikroeinschlüsse ausbilden. Dann wird ein zweiter Halbleiterwafer auf die Oberfläche des ersten Halbleiterwafers gebondet. Durch anschließendes thermisches Ausheilen wachsen die Mikroeinschlüsse in dem ersten Halbleiterwafer zu einer Trenn- oder Spaltfläche zusammen. An dieser Trennfläche kann dann der zweite Halbleiterwafer und die angebondete Schicht des ersten Halbleiterwafers leicht abgetrennt werden. Aufgrund der Ionenimplantation ist dieses Verfahren jedoch für lowcost-Anwendungen zu aufwendig.

Aus der EP-A-0 797 258 ist ebenfalls ein Verfahren bekannt, bei welchem poröses Siliziummaterial zum Einsatz kommt. Bei diesem Verfahren wird zunächst in der Oberfläche eines ersten Siliziumwafers durch anodisches Ätzen eine poröse Schicht erzeugt. Durch thermisches Ausheilen wird anschließend in der porösen Siliziumschicht durch Zusammenwachsen von Poren in einer bestimmten Tiefe eine Trenn- oder Spaltschicht erzeugt. Gleichzeitig wird die Oberfläche der porösen Siliziumschicht rekristallisiert, so daß auf dieser eine kristalline Siliziumschicht epitaktisch aufgewachsen werden kann. Auf diese epitaktische Schicht wird dann ein beliebiges Fremdsubstrat gebondet, welches an der Trennschicht des porösen Siliziums abgetrennt werden kann. Dieses Verfahren zeigt zwar eine relativ gute Materialausnutzung, ist aber aufgrund der Tatsache, daß ein Epitaxieschritt eingesetzt werden muß, technologisch sehr aufwendig.

Die EP-A-0 553 852 beschreibt schließlich anhand der Figuren 8A-C ein Verfahren, bei welchem ein monokristallines Silizium-Substrat zunächst in poröses Silizium umgewandelt wird, worauf anschließend eine Oberflächenschicht durch eine Wärmebehandlung rekristallisiert wird. Anschließend wird das Substrat mit der rekristallisierten Schicht auf ein anderes, mit einer Oxidschicht versehenes Silizium-Substrat gebondet und das poröse Silizium wird durch einen Ätzschritt entfernt.

Die herkömmlichen Verfahren sind somit für die Herstellung elektronischer Bauelemente, insbesondere Solarzellen, entweder aufgrund der erzielbaren Schichtdicken unvorteilhaft oder aufgrund ihrer Technologie sehr aufwendig und deshalb auch mit hohen Kosten verbunden.

Demzufolge liegt der vorliegenden Erfindung die Aufgabe zugrunde, ein Verfahren zur Herstellung ausreichend dünner kristalliner, quasikristalliner oder quasimonokristalliner Halbleiterschichten anzugeben, welches eine geringere Anzahl von Prozeßschritten enthält, somit technologisch weniger aufwendig ist und eine kostengünstige Fertigung von elektronischen und optoelektronischen Bauelementen auf der Basis der Halbleiterschichten ermöglicht.

Dieses Verfahren wird durch die Verfahrensschritte des Patentanspruchs 1 gelöst. Bei dem erfindungsgemäßen Verfahren wird an der Oberfläche eines Halbleitersubstrats mindestens eine poröse Schicht in dem Halbleitermaterial erzeugt, die poröse Schicht wird von dem Halbleitersubstrat abgelöst und entweder vor oder nach dem Ablösen durch thermisches Ausheilen mindestens teilweise rekristallisiert. Im Gegensatz zu der EP-A-0 797 258 wird somit die poröse Siliziumschicht nicht als Opferschicht ( 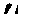 sacrificial layer"), verwendet. Vielmehr wird aus ihr selbst durch eine Wärmebehandlung eine kristalline Halbleiterschicht erzeugt, die in einem elektronischen oder optoelektronischen Bauelement als aktive Schicht nutzbar ist.

Erfindungsgemäß kann dies auf zwei unterschiedliche Ausführungsarten geschehen.

Gemäß einer ersten Ausführungsart weist das erfindungsgemäße Verfahren die Verfahrensschritte auf:
a) Bereitstellen eines Halbleitersubstrats mit einer Oberfläche;
b) Erzeugen einer an der Oberfläche angrenzenden ersten porösen Schicht mit einem ersten Porositätsverlauf in einem Bereich relativ niedriger Porosität;
c) Erzeugen einer zweiten porösen Schicht innerhalb der oder angrenzend an die erste poröse Schicht mit einem zweiten Porositätsverlauf, der zumindest teilweise in einem Bereich relativ hoher Porosität liegt;
d) Thermisches Ausheilen, wodurch die erste poröse Schicht (21) zumindest teilweise rekristallisiert und die zweite poröse Schicht mindestens teilweise in eine Trennschicht (23) umgewandelt wird;
e) Ablösen der rekristallisierten Schicht an der Trennschicht.

Im Gegensatz zu der bereits beschriebenen Ausführungsform in der EP-A-0 553 852, bei der im letzten Verfahrensschritt das poröse Silizium durch einen Ätzschritt entfernt wird, wird bei der ersten Ausführungsart der vorliegenden Erfindung im letzten Verfahrensschritt die rekristallisierte Schicht zumindest vertikal in einem Stück an der Trennschicht abgelöst oder abgehoben. In lateraler Richtung kann die rekristallisierte Schicht auch in mehreren Stücken abgehoben werden.

Gemäß einer zweiten Ausführungsart weist das erfindungsgemäße Verfahren die Verfahrensschritte auf:
a) Bereitstellen eines Halbleitersubstrats mit einer Oberfläche;
b) Erzeugen einer an der Oberfläche angrenzenden porösen Schicht mit einem ersten Porositätsverlauf in einem Bereich relativ niedriger Porosität;
c) Erzeugen einer zweiten porösen Schicht innerhalb der oder angrenzend an die erste poröse Schicht mit einem zweiten Porositätsverlauf, welcher derart beschaffen ist, daß eine ganzflächige Ablösung der porösen Schichten während des Prozesses erfolgt;
d) Thermisches Ausheilen und somit zumindest teilweises Rekristallisieren der porösen Schichten.

Weitere vorteilhafte Ausgestaltungen des erfindungsgemäßen Verfahrens sind in den Unteransprüchen angegeben.

Insbesondere kann die Herstellung des porösen Silizium durch anodisches Ätzen erfolgen, bei welchem beispielsweise eine Zweikammer-Ätzzelle verwendet wird und fluorwasserstoffhaltige Ätzlösungen eingesetzt werden.

Mit dem erfindungsgemäßen Verfahren können kristalline, quasikristalline oder quasimonokristalline Halbleiterschichten mit einstellbarer Schichtdicke von sub-µm bis einige 10 µm auf beliebige Substrate aufgebracht und als aktive Schicht elektronischer und optoelektronischer Bauelemente, insbesondere Solarzellen genutzt werden. Für eine Nutzung als aktive Schicht einer Solarzelle kann es sich dabei als vorteilhaft erweisen, daß in der rekristallisierten Schicht Fehlvolumina verblieben sind, die als Lichtstreuzentren wirken und somit die Lichtabsorption erhöhen. Die durch diese Fehlvolumina gebildeten inneren Oberflächen können zusätzlich z.B. durch eine Wasserstoffbehandlung oder durch ein lokales Feld (hohe Dotierung an der Oberfläche) bzw. durch eine dünne Oxidschicht durch Einbringen von stabilen Ladungen oder durch Inversionsschichten passiviert werden.

Im folgenden werden Ausführungsbeispiele der vorliegenden Erfindung in Verbindung mit den Zeichnungen näher erläutert.

Es zeigen:
Fig.1 eine für das erfindungsgemäße Verfahren verwendete Zweikammer-Ätzzelle;
Fig. 2A bis F die einzelnen Stadien eines Herstellungsprozesses nach einer ersten Ausführungsart der vorliegenden Erfindung;
Fig. 3A bis D die einzelnen Stadien eines Herstellungsprozesses nach einer zweiten Ausführungsart der vorliegenden Erfindung;
Fig. 4 der Absorptionskoeffizient einer erfindungsgemäß hergestellten kristallinen Siliziumschicht (experimentell gemessen) und von kristallinem Silizium (Literatur).

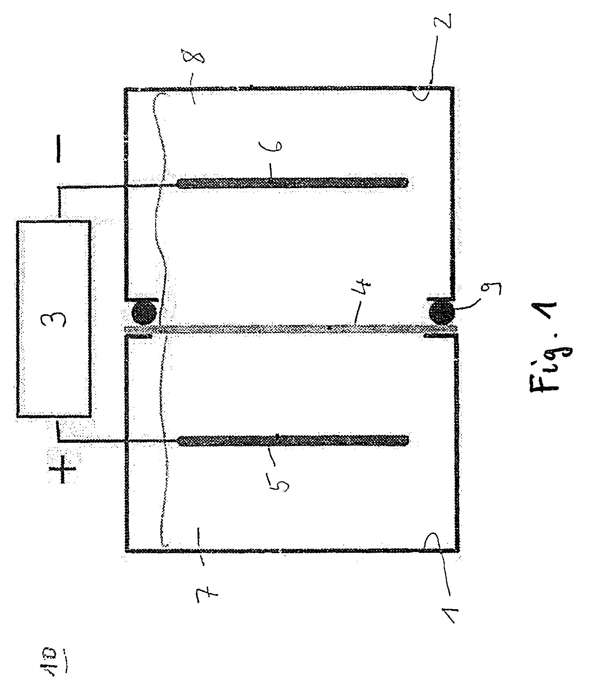

In Fig.1 ist eine an sich bekannte Zweikammer-Ätzzelle 10 dargestellt, wie sie beispielsweise für die Erzeugung porösen Siliziums verwendet werden kann. Die Zelle besteht aus zwei Kammern 1 und 2, die durch den zu bearbeitenden Halbleiterwafer 4 räumlich voneinander getrennt sind. Der Halbleiterwafer 4 wird unter Verwendung eines Dichtungsrings 9 flüssigkeitsdicht in die Zelle eingespannt. In der Kammer 2 befindet sich eine Fluorwasserstoff (HF)/Ethanol-Ätzlösung 8, während die Kammer 1 mit einem Kontaktierelektrolyten 9, wie beispielsweise H₂SO₄, gefüllt ist. In die Flüssigkeiten beider Kammern sind Elektroden 5 und 6, beispielsweise aus Platin, eingetaucht, die mit den Polen einer Stromquelle 3 verbunden sind. Die zu bearbeitende Oberfläche des Halbleiterwafers 4 ist der Kathode 6 zugewandt. Mit der Stromquelle 3 kann eine Stromdichte im Bereich von 1 - 300 mA/cm² erzielt werden. Die Temperatur kann in einem Bereich von etwa -20°C bis 80°C liegen. Typischerweise liegt sie bei Raumtemperatur.

Im folgenden wird eine erste Ausführungsart anhand der Figuren 2A bis F näher erläutert. Als Halbleiter wird Silizium verwendet.

Zunächst wird gemäß Fig.2A ein geeignetes mono- oder polykristallines Siliziumsubstrat bereitgestellt. Als Substratmaterial kommt sowohl n- als auch p-Typ-Silizium in Frage. Die Orientierung spielt dabei keine entscheidende Rolle. Das Ausgangsmaterial kann je nach Anwendung sägerauh, texturiert oder poliert vorliegen.

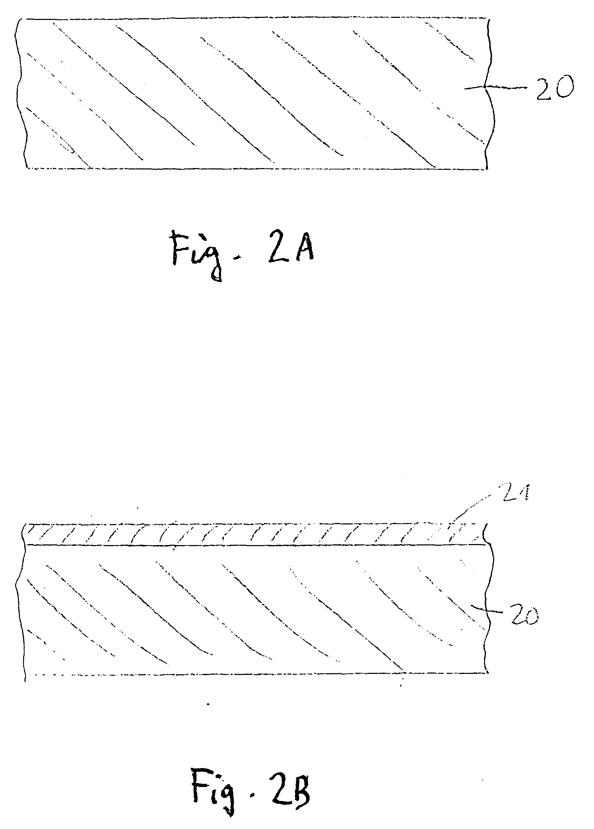

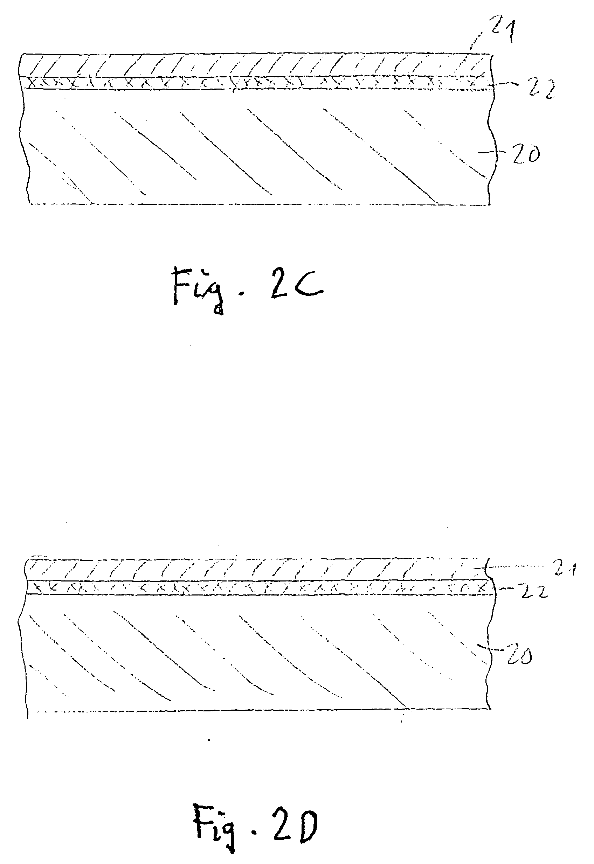

Dann wird durch anodisches Ätzen in einem in Fig.1 beschriebenen Zweikammersystem in an sich bekannter Weise eine erste poröse Oberflächenschicht 21 hergestellt (Fig.2B). Die Schicht 21 kann entweder eine räumliche konstante, relativ niedrige Porosität oder einen Porositätsverlauf in einem Bereich relativ niedriger Porosität über die Tiefe aufweisen. Die HR-Konzentration muß zur Erzielung einer geringen Porosität relativ hoch sein, d.h. in einem Bereich 5-50%, beispielsweise 37%. Die Stromdichte wird zur Erzielung einer geringen Porosität in einem Bereich von auf 1 - 30 mA/cm² eingestellt. Die Schichtdicke wird durch die Ätzzeit bestimmt. Bei einer Stromdichte von z.B. 12 mA/cm² entsteht in 10 Minuten eine poröse Schicht mit einer Dicke von ca. 10µm mit einer Porosität von ca. 20-30%.

Gemäß Fig.2C wird dann in einem zweiten Ätzschritt eine zweite relativ dünne poröse Schicht 22 hergestellt. Diese Schicht kann eine räumlich konstante, relativ hohe Porosität oder einen Porositätsverlauf in einem Bereich relativ hoher Porosität aufweisen. In einer bevorzugten Ausführungsform wird ein Porositätsverlauf erzeugt, indem dieser Ätzschritt mit einer zeitabhängigen Stromdichte durchgeführt wird. Bei Experimenten wurden sehr gute Ergebnisse mit einer Stromrampe erzielt, bei der bei einer HF-Konzentration von 37% die Stromdichte zunächst in 10 Sekunden von 12 mA/cm² auf 50 mA/cm² erhöht wurde, dann 10 Sekunden bei 50 mA/cm² konstant gehalten wurde und schließlich in 10 Sekunden auf den Wert 0 zurückgeführt wurde. Mit dieser Prozeßführung kann die zweite poröse Schicht 22 an der Grenzfläche zwischen der ersten porösen Schicht 21 und dem kristallinen Substrat 20 mit einer Schichtdicke von 50-2000 nm gebildet werden. Entsprechend dem Stromprofil weist die Porosität der zweiten Schicht 22 einen tiefenabhängigen Verlauf auf. Beginnend an der Grenzfläche steigt zunächst die Porosität langsam an, verbleibt dann über einen schmalen Tiefenbereich auf einem konstanten und relativ hohen Niveau und fällt daran anschließend wieder langsam ab. Wenn durch den anfangs relativ niedrigen Strom die Porosität in der Tiefe ansteigt, steigt auch der Widerstand der soeben erzeugten Schicht. Umso höher dieser Widerstand ist, um so besser sind darüberliegende Schichten gegen den Ätzangriff passiviert, wodurch die zweite poröse Schicht 22 in der Tiefe an der Grenzfläche zwischen der ersten porösen Schicht 21 und dem kristallinen Substrat 20 erzeugt wird.

Die Erzeugung der zweiten porösen Schicht 22 kann auch, wie etwa beschrieben in der EP-A-0 797 258, mit einem zeitunabhängigen Strom durchgeführt werden. Dabei kann beispielsweise die Ätzzeit auf wenige Sekunden, beispielsweise zwischen 2 und 3 Sekunden und die Stromdichte auf einen konstanten Wert in einem Bereich zwischen 60 und 200 mA/cm² eingestellt werden. Damit entsteht eine poröse Schicht 22 mit einer Dicke von 50 - 100 nm und einer tiefenunabhängigen Porosität, die zumindest größer als die der ersten Schicht 21 ist. Bei Wahl einer relativ niedrigen Stromdichte, wie etwa 60 mA/cm², entsteht die poröse Trennschicht an der Grenzfläche zum kristallinen Substrat, wenn eine relativ hohe HF - Konzentration vorliegt, während sie bei Wahl einer relativ hohen Stromdichte, wie etwa 200 mA/cm², und vergleichsweise niedriger HF - Konzentration in der Mitte der ersten porösen Schicht 21 gebildet wird.

Es ist generell von Vorteil, wenn die zweite poröse Schicht 22 an der Grenzfläche zwischen der ersten porösen Schicht 21 und dem kristallinen Substrat 20 gebildet wird, da in diesem Fall - wie noch zu sehen sein wird - nach dem Ablösen der Schichten das Substrat nicht aufwendig durch Polieren etc. nachbehandelt werden muß und im übrigen das Material optimal ausgenutzt wird.

Nach Vollendung der Ätzprozesse wird der Siliziumwafer aus der Zweikammerzelle entnommen. Die Handhabung der Schicht wird dadurch erleichtert, daß die erste poröse Schicht 21 von unten durch die zweite poröse Schicht 22 stabil fixiert wird. Eine ausreichende Stabilität der Schicht 22 wird bei der oben beschriebenen Herstellung durch die Ätzparameter gewährleistet.

Die porösen Schichten sind am Rand, der nicht geätzt ist, mit dem Wafer verbunden und werden dadurch zusätzlich fixiert.

Die nun folgende thermische Behandlung der Probe kann in einem Temper- oder RTP- (Rapid Thermal Processing)Ofen, durch Einwirkung eines Laserstrahls oder durch Einkopplung von elektromagnetischer Strahlung durchgeführt werden. Die Temperaturen liegen bei Durchführung der Wärmebehandlung in einem Vakuum oder in einem Schutzgas (z.B. Ar, He, H oder N2 oder Gasgemische aus verschiedenen Schutzgasen) typischerweise in einem Bereich von ca. 600°C bis unterhalb des Schmelzpunktes von kristallinem Silizium. Typische Parameter sind eine Temperatur von 1050°C und eine Dauer von 2 Stunden unter Vakuumbedingungen. Vorzugsweise sollten die Porenwände der Probe vor dem Ausheilungsprozeß vollständig von Oxid befreit werden und wasserstoffterminiert sein. Dies geschieht beispielsweise durch Ätzen in wäßrigen HF-Lösungen, wobei durch die Prozeßatmosphäre eine erneute Oxidation verhindert werden muß.

Die Temperaturbehandlung hat im wesentlichen zweierlei zur Folge.

Einerseits bewegen sich aus energetischen Gründen Atome aus stark porösem Material in Richtung weniger stark porösen Materials, d.h. die Atome wandern aus der stark porösen Schicht 22 sowohl in die schwach poröse Schicht 21 als auch an das kristalline Substrat 20 unter Beibehaltung der Kristallorientierung. Es bleibt lediglich eine dünne Trennschicht 23 (Fig.2E) zurück, die nur noch aus sehr dünnen fragilen Stegen besteht, an denen die schwach poröse Schicht 21 nach Art eines Reißverschlusses an dem Substrat 20 gehalten wird. Die Trennschicht 23 dient somit als Sollbruchstelle, um die darüberliegende Schicht 21 nach dem Temperprozeß von dem Substrat zu trennen.

Die Temperaturbehandlung bewirkt andererseits, daß die schwach poröse Schicht 21 mindestens teilweise rekristallisiert wird. Das bedeutet, daß unabhängig von der Dicke der Schicht die Poren an der Oberfläche nahezu vollständig ausheilen, so daß eine zusammenhängende Oberfläche entsteht. Bei sehr dünnen Schichten (bis ca. 1 µm) erfolgt die Rekristallisierung auch im Volumen vollständig. Bei größeren Dicken ist es zur Vermeidung von Fehlvolumina erforderlich, auch in der ersten porösen Schicht 21 einen Porositätsgradienten zu erzeugen. Dies hat zur Folge, daß der Ausheilungsprozeß bei der Temperaturbehandlung gerichtet erfolgt, wodurch Fehlvolumina vollständig ausgeheilt werden können.

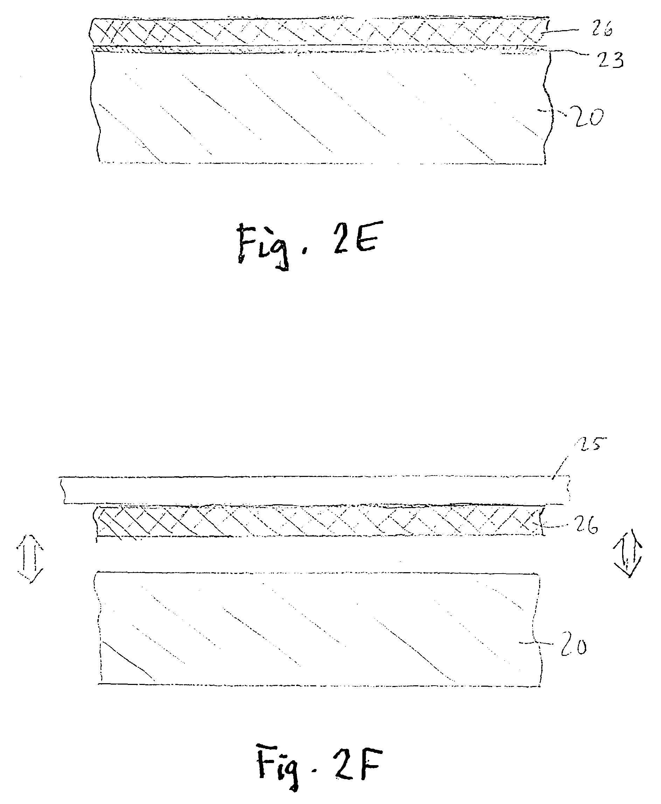

Nach der Temperaturbehandlung kann die rekristallisierte Schicht 26 an der Trennschicht 23 abgetrennt werden. Zu diesem Zweck kann beispielsweise gemäß Fig.2F auf die Oberfläche der Probe ein Substrat 25 durch Kleben oder Bonden aufgebracht werden. Das Substrat 25 kann einerseits ein Hilfsträger oder ein gewünschtes Fremdsubstrat aus Glas, Kunststoff oder dergleichen sein, welches mit einer kristallinen Siliziumschicht versehen werden soll. Das Substrat 25 kann nach dem Aufbringen mit der rekristallisierten Schicht 26 abgehoben werden.

Alternativ dazu kann das Substrat 25 auch vor dem Temperschritt aufgebracht werden.

Das Siliziumsubstrat kann danach erneut mit oder ohne Aufbereitung (z.B. Politur) zur Herstellung weiterer Schichten verwendet werden. Ein Polieren der Oberfläche zwischen den Zyklen vermindert die Rauhigkeit der einkristallinen Schichten.

Im folgenden wird eine zweite Ausführungsart anhand der Figuren 3A bis F näher erläutert.

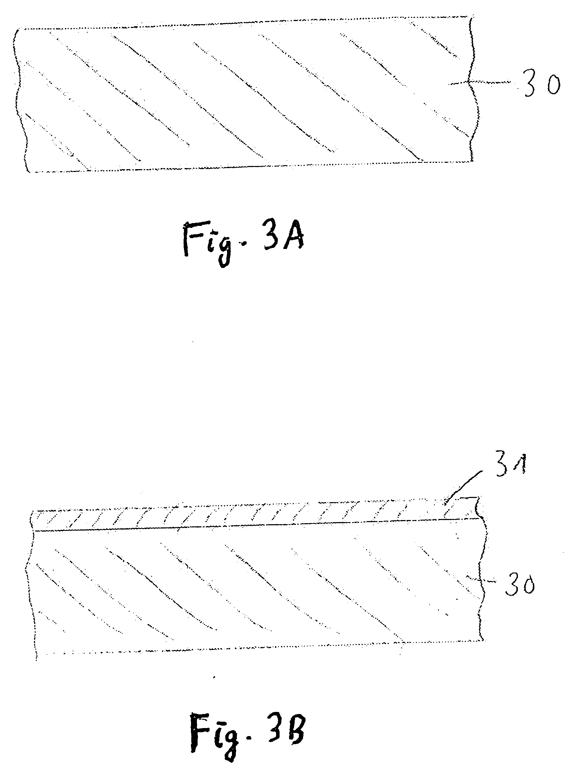

In den Figuren 3A,B ist dargestellt, wie auf einem einkristallinen Siliziumsubstrat 30 eine erste poröse Schicht 31 einer relativ geringen Porosität erzeugt wird. Dieser Verfahrensschritt kann ebenso wie bei der ersten Ausführungsart erfolgen. Es wird somit auf die Figuren 2A,B und die zugehörige Beschreibung verwiesen.

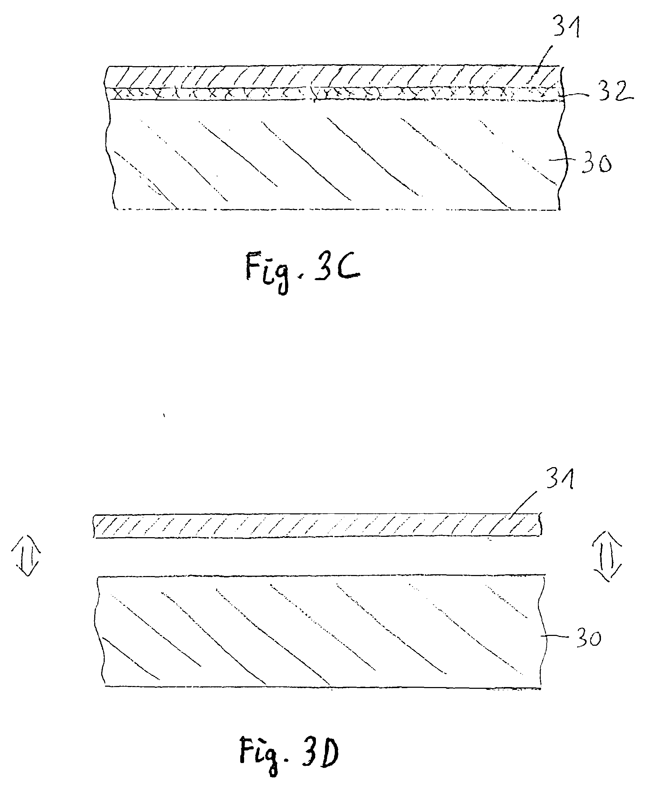

Im folgenden soll die schwach poröse Siliziumschicht durch den Ätzprozeß ganzflächig abgelöst werden. Dazu wird durch Änderung der Ätzparameter kurzzeitig eine Schicht 32 gebildet (Fig.3C), die eine relativ hohe Porosität aufweist. Im Gegensatz zu der ersten Ausführungsart werden die Ätzparameter während der Bildung der Schicht 32 so geändert, daß sich die schwach poröse Schicht 31 ganzflächig während dem Ätzprozeß ablöst (Fig.3D).

Dafür gibt es grundsätzlich zwei Möglichkeiten. Zum einen kann eine sehr hohe Stromdichte eingestellt werden, typischerweise im Bereich 100-300 mA/cm², abhängig unter anderem von der eingestellten HF-Konzentration. Es kann jedoch auch die Ätzlösung gegen eine andere mit geringerer (1-20%) HF-Konzentration ausgetauscht werden, die bei gleicher Stromdichte eine höhere Porosität erzeugt.

Beispielsweise kann zum Ablösen der Schicht bei einer Konzentration von 13,5% die Stromdichte durch eine Rampe in ca. 15 Sekunden auf 160mA/cm² hochgefahren und auf diesem Niveau für ca. 5 Sekunden gehalten werden. Im letzten Schritt muß die abgelöste Schicht 31 noch einer

Temperaturbehandlung mit dem Ziel ihrer Rekristallisierung unterzogen werden. Diesbezüglich wird auf die entsprechenden Ausführungen bezüglich Fig.2E der ersten Ausführungsart verwiesen.

Der Ätzprozeß kann ebenso mit einer Einkammer-Ätzzelle durchgeführt werden, in welcher die Anode durch den Halbleiterwafer gebildet wird.

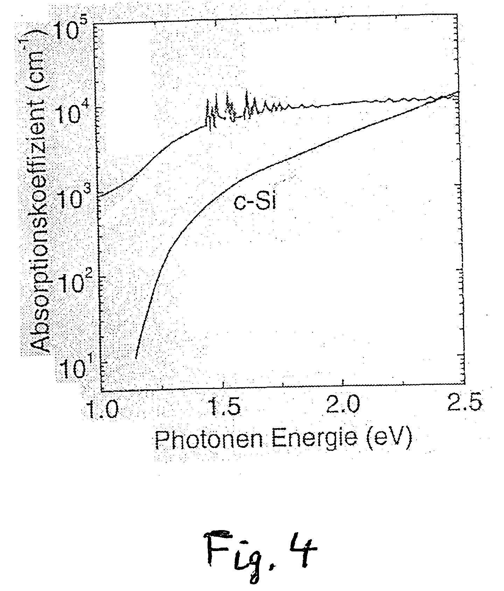

Experimentell wurde ermittelt, daß die erfindungsgemäß hergestellten kristallinen Siliziumschichten eine gegenüber kristallinem Silizium-Ausgangsmaterial erhöhte Lichtabsorption aufweisen. In Fig.4 ist die Absorptionskurve einer 4 µm dicken erfindungsgemäß hergestellten Siliziumschicht im Vergleich mit der Absorptionskurve von gewöhnlichem kristallinem Silizium dargestellt. Es zeigt sich, daß die erfindungsgemäß hergestellte Schicht über fast den gesamten sichtbaren Spektralbereich eine deutlich höhere Lichtabsorption aufweist. Die Erklärung dafür ist, daß die in dem Material verbliebenen und eingeschlossenen Fehlvolumina als sehr effektive Lichtstreuzentren wirken. Sie haben somit den gleichen Effekt wie eine texturierte Oberfläche, die durch Mehrfachreflexion an der Oberfläche ebenfalls eine bessere Lichtausbeute ermöglicht. Somit sind die erfindungsgemäß hergestellten Halbleiterschichten besonders gut für Solarzellen oder Photoempfänger geeignet.

Insbesondere bei der Anwendung für Solarzellen oder Photoempfänger kann die poröse und zu rekristallisierende Halbleiterschicht auch mit einer Oberflächenstrukturierung, insbesondere mit einer Texturierung wie einer Pyramidentextur versehen werden. Dies kann entweder vor dem Ätzprozeß an der kristallinen Ausgangsoberfläche geschehen, es kann jedoch auch in den Ätzprozeß mit eingebunden werden oder anschließend an den Ätzprozeß durchgeführt werden. Die texturierte Oberfläche der fertiggestellten kristallisierten Halbleiterschicht bildet zusammen mit den eingeschlossenen Fehlvolumina eine Struktur, mit der eine hohe Lichtabsorption und somit bei Solarzellen hohe Konversionswirkungsgrade zu erwarten sind.

Die erfindungsgemäß hergestellten Halbleiterschichten sind jedoch auch für andere Bauelemente wie Transistoren, insbesondere Dünnschichttransistoren, mikromechanische Bauelemente bzw. Systeme, Sensoren oder strahlungsresistente Elektronikschaltungen geeignet.

Als Ausgangsmaterial können auch andere Halbleitermaterialien wie Si-Verbindungen oder III-V-Verbindungen oder II-VI-Verbindungen verwendet werden. Für jedes dieser Materialien können versuchsweise als Ätzlösung ebenfalls fluorwasserstoffhaltige Lösungen verwendet werden.

Weiterhin kann vor der Temperaturbehandlung in die an der Oberfläche der porösen Schicht nach außen offenen Poren ein anderes Material, beispielsweise ein anderes Halbleitermaterial eingebracht werden. Dies kann beispielsweise durch ein elektrolytisches Verfahren, durch einen Aufdampfprozeß oder aus der flüssigen Phase durchgeführt werden. Das entstandene Material ist dann ein Mischhalbleiter oder eine Legierung. Durch die anschließende Temperaturbehandlung können damit neue Materialien mit bisher anderweitig nicht erzielbaren Zusammensetzungen erreicht werden.

## Patentansprüche

1. Verfahren zur Herstellung einer kristallinen Halbleiterschicht (26), bei welchem
- an der Oberfläche eines Halbleitersubstrats (20; 30) mindestens eine poröse Schicht (21; 31) erzeugt wird,
- die poröse Schicht von dem Halbleitersubstrat abgelöst wird und
- entweder vor oder nach dem Ablösen durch thermisches Ausheilen mindestens teilweise rekristallisiert wird.

2. Verfahren nach Anspruch 1, mit den Verfahrensschritten
a) Bereitstellen eines Halbleitersubstrats (20) mit einer Oberfläche;
b) Erzeugen einer an der Oberfläche angrenzenden ersten porösen Schicht (21) mit einem ersten Porositätsverlauf in einem Bereich relativ niedriger Porosität;
c) Erzeugen einer zweiten porösen Schicht (22) innerhalb der oder angrenzend an die erste poröse Schicht (21) mit einem zweiten Porositätsverlauf, der zumindest teilweise in einem Bereich relativ hoher Porosität liegt;
d) Thermisches Ausheilen, wodurch die erste poröse Schicht (21) zumindest teilweise rekristallisiert und die zweite poröse Schicht mindestens teilweise in eine Trennschicht (23) umgewandelt wird;
e) Ablösen der rekristallisierten Schicht (26) an der Trennschicht (23).

3. Verfahren nach Anspruch 1, mit den Verfahrensschritten
a) Bereitstellen eines Halbleitersubstrats (30) mit einer Oberfläche;
b) Erzeugen einer an der Oberfläche angrenzenden porösen Schicht (31) mit einem ersten Porositätsverlauf in einem Bereich relativ niedriger Porosität;
c) Erzeugen einer zweiten porösen Schicht (31) innerhalb der oder angrenzend an die erste poröse Schicht (31) mit einem zweiten Porositätsverlauf, welcher derart beschaffen ist, daß eine ganzflächige Ablösung der porösen Schichten während des Prozesses erfolgt;
d) Thermisches Ausheilen und somit zumindest teilweises Rekristallisieren der porösen Schichten.

4. Verfahren nach Anspruch 2, bei welchem im Verfahrensschritt b) die erste poröse Schicht (21) eine stetige Zunahme der Porosität in Tiefenrichtung aufweist.

5. Verfahren nach Anspruch 2, bei welchem die zweite poröse Schicht (22) ein relatives Maximum der Porosität in Abhängigkeit von der Tiefenrichtung aufweist.

6. Verfahren nach Anspruch 2 oder 3, bei welchem die zweite poröse Schicht (32) eine stetige Zunahme der Porosität in Tiefenrichtung aufweist.

7. Verfahren nach Anspruch 2, bei welchem der Verfahrensschritt e) dadurch erfolgt, daß unmittelbar auf die Oberfläche des Halbleitersubstrats ein Fremdsubstrat (25) aufgebracht wird und das Fremdsubstrat (25) anschließend zusammen mit der teilweise kristallisierten Schicht von dem Halbleitersubstrat abgehoben wird.

8. Verfahren nach einem der Ansprüche 1 bis 7, bei welchem vor dem Ätzprozeß eine makroskopische Oberflächenstruktur in der Halbleiterschicht, insbesondere eine Textur wie eine Pyramidentextur erzeugt wird.

9. Verfahren nach einem der Ansprüche 1 bis 8, bei welchem vor dem thermischen Ausheilen ein weiteres Material, insbesondere ein weiteres Halbleitermaterial, in die an der Oberfläche der ersten porösen Schicht (21) nach außen offenen Poren eingebracht wird.

10. Elektronisches Bauelement, insbesondere eine Solarzelle oder ein Photoempfänger, ein Dünnschichttransistor, ein Sensorbauelement, ein mikromechanisches Bauelement oder System, ein integrierter Schaltkreis oder ein strahlungsresistentes Bauelement, jeweils enthaltend eine kristalline Halbleiterschicht, hergestellt nach einem Verfahren gemäß einem oder mehreren der vorhergehenden Ansprüche.
